(19) 

Europäisches
Patentamt

European
Patent Office

Office européen
des brevets

(11) **EP 3 228 640 A1**

(12) **EUROPEAN PATENT APPLICATION**
published in accordance with Art. 153(4) EPC

(43) Date of publication:
**11.10.2017 Bulletin 2017/41**

(21) Application number: **15865023.4**

(22) Date of filing: **26.11.2015**

(51) Int Cl.:
**C08F 220/12** (2006.01)   **B82Y 20/00** (2011.01)
**B82Y 30/00** (2011.01)   **C08F 2/44** (2006.01)
**C08F 216/12** (2006.01)   **G02B 1/04** (2006.01)
**H01L 33/50** (2010.01)   **H01L 33/56** (2010.01)

(86) International application number:
**PCT/JP2015/083246**

(87) International publication number:
**WO 2016/088646 (09.06.2016 Gazette 2016/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **04.12.2014 JP 2014245851**

(71) Applicant: **Showa Denko K.K.
Tokyo 105-8518 (JP)**

(72) Inventors:
• **YAMAKI Shigeru**
  **Tokyo 105-8518 (JP)**
• **SEKINE Takashi**
  **Tokyo 105-8518 (JP)**
• **YOKOYAMA Ayako**
  **Tokyo 105-8518 (JP)**

(74) Representative: **Strehl Schübel-Hopf & Partner
Maximilianstrasse 54
80538 München (DE)**

(54) **CURABLE COMPOSITION CONTAINING SEMICONDUCTOR NANOPARTICLES, CURED PRODUCT, OPTICAL MATERIAL AND ELECTRONIC MATERIAL**

(57)   The present invention provides a curable composition containing semiconductor nanoparticles, which contains luminescent semiconductor nanoparticles having good dispersibility and has low viscosity and excellent formability. A curable composition containing semiconductor nanoparticles, contains: a monofunctional (meth)acrylate compound (a) having a tricyclodecane structure; at least one compound (b) selected from among (meth)acrylate compounds (b1) having two or more (meth)acryloyloxy groups and compounds (b2) represented by formula (1); a polymerization initiator (c); and luminescent semiconductor nanoparticles (d). $H_2C=C(R^1)-CH_2-O-CH_2-C(R^2)=CH_2$ (1) (In formula (1), $R^1$ and $R^2$ each independently represent a hydrogen atom, an alkyl group having 1 to 4 carbon atoms, or an organic group having 4 to 10 carbon atoms having an ester bond)

**EP 3 228 640 A1**

**Description**

Technical field

The present invention relates to a curable composition containing semiconductor nanoparticles, a cured product, an optical material and an electronic material. More specifically, the present invention relates to a curable composition containing semiconductor nanoparticles, a cured product obtained by curing the curable composition containing semiconductor nanoparticles, and an optical material and an electronic material comprising the cured product thereof.

Priority is claimed based on Japanese Patent Application No. 2014-245851, filed in Japan on Dec. 4, 2014, the content of which is incorporated herein by reference.

Background Art

Resin materials are used as electronic materials and optical materials used for electronic parts and optical parts such as optical lenses, optical elements, optical waveguides and sealing materials for LED (Light Emitting Diode).

Conventionally, as a resin material used for an LED sealing material, there is a phosphor-containing composition containing silica fine particles, a phosphor, and a liquid medium (see, for example, Patent Document 1).

In addition, a curable composition usable for an LED sealing material or the like contains silica fine particles, (meth)acrylate having two or more ethylenically unsaturated groups and having no ring structure, an ethylenically unsaturated group (meth)acrylate having an alicyclic structure, and a polymerization initiator, wherein silica fine particles are surface-treated with a silane compound (for example, see Patent Document 2).

In addition, a composite composition that can be used for an LED sealing material or the like contains a compound having a functional group and silica fine particles(see, for example, Patent Document 3). Patent Document 3 discloses that a compound having a functional group contains (meth)acrylate having an alicyclic structure and two or more functional groups.

In recent years, quantum dots exhibiting quantum confinement effect are attracting attention as nano-sized semiconductor particles. It is also studied to use such a quantum dot as a phosphor of an LED sealing material. For example, Patent Document 4 discloses a liquid curable resin composition containing a nanoparticle fluorescent substance and an inorganic fluorescent substance composed of a hydrocarbon group coordinated to the inorganic fluorescent substance.

Patent Literature

Patent Document 1: Japanese Unexamined Patent Application Publication 2009-102514
Patent Document 2: WO 2010/001875
Patent Document 3: Japanese Patent No. 5186848
Patent Document 4: Japanese Unexamined Patent Application Publication No. 2010-126596

Summary of the invention

Problem to be Solved by Invention

However, curable compositions containing conventional nano-sized semiconductor particles have problems such as poor dispersibility of semiconductor nanoparticles, high viscosity, poor formability, and the like. Further, the cured product obtained by curing the curable composition containing conventional nano-sized semiconductor particles has a low quantum yield, and the oxygen barrier property is insufficient.

The present invention has been made in view of the above circumstances. It is an object of the present invention to provide a curable composition containing luminescent semiconductor nanoparticles. This curable composition has good dispersibility of semiconductor nanoparticles, low viscosity and excellent formability.

It is another object of the present invention to provide a cured product obtained by curing the curable composition, an optical material and an electronic material comprising the cured product. This cured product has a high quantum yield and an excellent oxygen barrier property.

Means for solving the problem

The inventors of the present invention conducted intensive studies to solve the above-described problems, as a result, a curable composition containing semiconductor nanoparticles is provided. The curable composition contains a monofunctional (meth)acrylate compound having a tricyclodecane structure, at least one selected from the group consisting of a (meth)acrylate compound having two or more (meth)acryloyloxy groups and a compound represented by the following formula (1), a polymerization initiator, and a luminescent semiconductor nanoparticle. The curable composition has a low viscosity and excellent formability and dispersibility, and a cured product obtained by curing the curable composition has a high quantum yield and an excellent oxygen barrier property.

The present invention adopts the following constitution.

(1) A curable composition containing semiconductor nanoparticles comprising a monofunctional (meth)acrylate compound (a) having a tricyclodecane structure,
at least one compound (b) selected from the group consisting of a (meth)acrylate compound (b1) having two or more (meth)acryloyloxy groups and a compound (b2) represented by the following formula (1),
a polymerization initiator (c), and
a luminescent semiconductor nanoparticle (d),

$$H_2C=C(R^1)-CH_2-O-CH_2-C(R^2)=CH_2 \qquad (1)$$

wherein $R^1$ and $R^2$ each independently represent a hydrogen atom, an alkyl group having 1 to 4 carbon atoms, or an organic group having 4 to 10 carbon atoms having an ester bond.
(2) The curable composition containing semiconductor nanoparticles according to (1),
wherein the amount of the (meth)acrylate compound (a) with respect to the total mass of the (meth)acrylate compound (a) and the compound (b) is 75 to 99.5 % by mass.
(3) The curable composition containing semiconductor nanoparticles according to (1) or (2),
wherein the semiconductor nanoparticle (d) has a nanoparticle core containing an ion which is at least one element selected from the group consisting of Groups 2 to 16 of the periodic table.
(4) The curable composition containing semiconductor nanoparticles according to (3),
wherein the nanoparticle core is selected from the group consisting of ZnS, ZnSe, ZnTe, InP, InAs, InSb, A1S, AlAs, AlSb, GaN, GaP, GaAs, GaSb, PdS, PbSe, Si, Ge, MgSe, and MgTe.
(5) The curable composition containing semiconductor nanoparticles according to any one of (1) to (4),
wherein the semiconductor nanoparticle (d) comprises a nanoparticle core and a capping layer having a protective group coordinated to the surface of the nanoparticle core, and
the surface of the nanoparticle core is coated with at least one shell of an inorganic material.
(6) The curable composition containing semiconductor nanoparticles according to any one of (1) to (5),
wherein the amount of the semiconductor nanoparticles (d) in the curable composition containing semiconductor nanoparticles is 0.1 to 20% by mass.
(7) A cured product obtained by curing the curable composition containing semiconductor nanoparticles according to any one of (1) to (6).
(8) An optical material comprising the cured product according to (7).
(9) An electronic material characterized by comprising the cured product according to (7).

Effect of The Invention

The curable composition containing semiconductor nanoparticles of the present invention comprises a monofunctional (meth)acrylate compound having a tricyclodecane structure, at least one compound (b) selected from the group consisting of a (meth)acrylate compound (b1) having two or more (meth)acryloyloxy groups and a compound (b2) represented by the above formula (1), a polymerization initiator, and luminescent semiconductor nanoparticles. Therefore, the curable composition containing semiconductor nanoparticles of the present invention can utilize light wavelength converting action by containing semiconductor nanoparticles, has good dispersibility of semiconductor nanoparticles, has low viscosity and excellent formability.

Further, by curing the curable composition containing semiconductor nanoparticles of the present invention, a cured product which has high quantum yield, excellent oxygen barrier property and is suitably usable for optical materials and electronic materials can be obtained.

DETAILED DESCRIPTION OF THE INVENTION

Hereinafter, the curable composition containing semiconductor nanoparticles, the cured product obtained by curing the curable composition containing semiconductor nanoparticles, and the optical material and electronic material including the cured product will be disclosed in detail.

Note that the materials, dimensions, and the like shown in the following description are merely examples, and the present invention is not limited thereto. The present invention can be implemented with appropriate modifications within the scope not changing the gist thereof.

[Curable composition containing semiconductor nanoparticles]

The curable composition containing a semiconductor nanoparticle of the present invention includes a monofunctional (meth)acrylate compound (a) having a tricyclodecane structure (hereinafter also referred to as "(meth)acrylate (a)"), at least one compound (b) selected from the group consisting of (meth) acrylate compound (b1) having two or more (meth)acryloyloxy groups (hereinafter, also referred to as "(meth)acrylate (b1)") and a compound (b2) represented by the above formula (1), a polymerization initiator (c), and luminescent semiconductor nanoparticles (d).

In the present specification, "(meth)acrylate compound" means an acrylate compound and/or a methacrylate compound. Further, "two or more (meth)acryloyloxy groups" means two or more acryloyloxy groups when the (meth)acryloyloxy group is only an acryloyloxy group, two or more methacryloyloxy groups when the (meth)acryloyloxy group is only a methacryloyloxy group, or the sum of the acryloyloxy group and the methacryloyloxy group is 2 or more when the (meth)acryloyloxy group contains both an acryloyloxy group and a methacryloyloxy group.

Hereinafter, each component contained in the curable composition containing semiconductor nanoparticles of the present invention will be disclosed.

<(Meth)acrylate (a)>

(Meth)acrylate (a) is a monofunctional (meth)acrylate compound having a tricyclodecane structure. Here, monofunctional means having only one (meth)acryloyloxy group. (Meth)acrylate (a) has high interaction and dispersibility with the semiconductor nanoparticle (d). Therefore, since the (meth)acrylate (a) is contained, a curable composition containing semiconductor nanoparticles having good dispersibility of semiconductor nanoparticles and low viscosity is obtained. In addition, since the (meth)acrylate (a) is contained in the curable composition containing semiconductor nanoparticles, curing shrinkage when curing the curable composition containing semiconductor nanoparticles is suppressed and a cured product having excellent flexibility is obtained.

The (meth)acrylate (a) may be a monofunctional (meth)acrylate compound having a tricyclodecane structure, and a kind and/or a bonding position of the monofunctional group bonded to the tricyclodecane structure is not particularly limited. Further, the (meth)acrylate (a) may be a single compound or two or more kinds of compounds. It is preferable that the tricyclodecane structure is a tricyclo[5.2.1.0$^{2.6}$]decane structure.

The monofunctional (meth)acrylate compound (a) having a tricyclodecane structure is preferably (meth)acryloxy-tricyclodecane, more preferably (meth)acryloxy-tricyclo[5.2.1.0$^{2.6}$]decane is more preferable.

Specific examples of the (meth)acrylate (a) include 8-methacryloyloxy-tricyclo[5.2.1.0$^{2.6}$]decane and/or 8-acryloxy-tricyclo[5.2.1.0$^{2.6}$]decane.

The amount of the (meth)acrylate (a) with respect to the total mass of the (meth)acrylate (a) and the compound (b) is preferably 75 to 99.5% by mass. When the amount of the (meth)acrylate (a) with respect to the total mass is 75% by mass or more, the effect due to the inclusion of the (meth)acrylate (a) in the curable composition containing semiconductor nanoparticles has become more remarkable. Also, when the amount of the (meth)acrylate (a) with respect to the above-mentioned total mass exceeds 99.5% by mass, the amount of the compound (b) becomes relatively small. Therefore, it is difficult to obtain the effect of containing the compound (b) in the curable composition containing semiconductor nanoparticles. Therefore, the amount of the (meth)acrylate (a) with respect to the total mass of the (meth)acrylate (a) and the compound (b) is more preferably from 75 to 99.5 % by mass, and is still more preferably from 80 to 95 % by mass.

From the viewpoint of oxygen barrier property and dispersibility, it is preferably that the curable composition containing semiconductor nanoparticles of the present application does not contain a monofunctional (meth)acrylate compound (hereinafter sometimes referred to as "(meth)acrylate (e)") other than the monofunctional (meth)acrylate compound (a) having a tricyclodecane structure.

<Compound (b)>

The compound (b) is at least one selected from a (meth)acrylate compound (b1) having two or more (meth)acryloyloxy groups and the compound (b2) represented by the above formula (1).

(Meth)acrylate (b1) is (meth)acrylate compound having two or more (meth)acryloyloxy group. Since the (meth)acrylate (b1) is included in the curable composition containing semiconductor nanoparticles, a curable composition containing semiconductor nanoparticles which is less likely to form cracks during molding and has excellent formability is obtained. In addition, since the (meth)acrylate (b1) is contained in the curable composition containing semiconductor nanoparticles, the cured product obtained by curing the curable composition containing semiconductor nanoparticles is excellent in heat resistance .

As the (meth)acrylate (b1), it is preferable to use an ester of an aliphatic polyhydric alcohol and (meth) acrylic acid, or an adduct of a polyfunctional epoxy compound and (meth) acrylic acid. Specific examples of the (meth)acrylate (b1) include tricyclodecane dimethanol di(meth)acrylate, neopentyl di(meth)acrylate neopentyl glycol di(meth)acrylate, 1,6-hexanediol diacrylate, trimethylolpropane tri(meth)acrylate, pentaerythritol tri(meth)acrylate, pentaerythritol tetra(meth)acrylate, pentaerythritol tetra(meth)acrylate, dipentaerythritol tetra(meth)acrylate, dipentaerythritol penta(meth)acrylate, dipentaerythritol hexa(meth)acrylate, bisphenol A diglycidyl ether (meth)acrylic acid adduct, ethylene glycol diglycidyl ether (meth)acrylic acid adduct and the like.

The (meth)acrylate compound (b1) preferably has a tricyclodecane structure. More preferably, the (meth)acrylate compound (b1) is tricyclodecanedimethanol di (meth)acrylate.

Regarding a curable composition containing semiconductor nanoparticles includes (meth)acrylate compound (a) having a tricyclodecane structure, a (meth)acrylate compound (b1) having two or more (meth)acryloyloxy groups, a polymerization initiator (c), a luminescence, both the (meth)acrylate compound (a) and the (meth)acrylate compound (b1) may be tricyclodecane structure. More preferably, the (meth)acrylate compound (a) is (meth) acryloxy-tricyclodecane and the (meth)acrylate compound (b1) is tricyclodecanedimethanol di(meth)acrylate. Most preferably, the tricyclodecane is tricyclo[5.2.1.0$^{2,6}$]decane.

As the compound (b2) represented by the above formula (1), from the viewpoint of the dispersibility of the semiconductor nanoparticles in the curable composition containing semiconductor nanoparticles, an esterified product of 2-(allyloxymethyl)acrylic acid can be exemplified. Among them, methyl 2-(allyloxymethyl) acrylic acid is preferable.

The above compound (b) may be used alone, or two or more of them may be used in combination.

The amount of the compound (b) with respect to the total mass of the amount of (meth)acrylate (a) and the compound (b) is preferably at 25 % by mass or less. When the amount of the compound (b) with respect to the total mass is 25% by mass or less, the amount of the compound (b) decreases and the amount of the (meth)acrylate (a) relatively increases. Therefore, it becomes easy to obtain the effect due to the curable composition containing semiconductor nanoparticles containing (meth)acrylate (a). When the amount of the compound (b) with respect to the total mass of the (meth)acrylate (a) and the compound (b) is 0.5% by mass or more, the effect that the compound (b) is contained in the curable composition containing semiconductor nanoparticles is remarkable. Therefore, the amount of the compound (b) with respect to the above-mentioned total mass is more preferably from 0.5 to 25 % by mass, and is further more preferably from 5 to 20 % by mass.

The total amount of (meth)acrylate (a) and the compound (b) in the curable composition containing semiconductor nanoparticles is preferably 80-99.9% by mass.

<Polymerization Initiator (c)>

The polymerization initiator (c) contributes to curing the curable composition containing semiconductor nanoparticles. Examples of the polymerization initiator (c) include a photopolymerization initiator and/or a thermal polymerization initiator that generate radicals.

Examples of the photopolymerization initiator include benzophenone, benzoin methyl ether, benzoin propyl ether, diethoxy acetophenone, 1-hydroxy-phenyl phenyl ketone, 2,6-dimethyl benzoyl diphenyl phosphine oxide, diphenyl-(2,4,6-Trimethylbenzoyl) phosphine oxide, bis (2,4,6-trimethylbenzoyl) phenylphosphine oxide, oligomers of 2-hydroxy-1-(4-isopropenylphenyl)-2-methylpropan-1-one, 4,6-trimethylbenzoyldiphenylphosphine oxide, 2,4,6-trimethylbenzophenone, and the like. These photopolymerization initiators may be used alone, or two or more of them may be used in combination.

Examples of the polymerization initiator containing two or more photopolymerization initiators include a mixture of oligomers of 2-hydroxy-1-(4-isopropenylphenyl)-2-methylpropane-1-one, 2,4,6-trimethyl benzoyldiphenylphosphine oxide and 2,4,6-trimethylbenzophenone, and the like.

Examples of the thermal polymerization initiator include benzoyl peroxide, diisopropyl peroxycarbonate, t-butyl peroxy (2-ethylhexanoate), t-butyl peroxyneodecanoate, t-hexyl peroxypivalate, 1,1,3,3 -tetramethylbutylperoxy-2-ethylhexanoate, t-butylperoxy pivalate, t-butylperoxy-2-ethylhexanoate, t-hexylperoxyisopropyl monocarbonate, dilauroyl peroxide, diisopropyl peroxydicarbonate, di(4-t-butylcyclohexyl) peroxydicarbonate, 2,2-di(4,4-di-(t-butylperoxy)cyclohexyl) propane. These thermal polymerization initiators may be used alone or a combination of two or more kinds may be used.

The amount of the polymerization initiator (c) in the curable composition containing semiconductor nanoparticles may be any amount as long as the curable composition containing semiconductor nanoparticles is appropriately cured. The amount of the polymerization initiator in the curable composition containing semiconductor nanoparticles is preferably 0.01 to 10 % by mass, more preferably 0.02 to 5 % by mass, further preferably 0.1 by mass to 2% by mass.

When the amount of the polymerization initiator is too large, the storage stability of the curable composition containing semiconductor nanoparticles may decrease or it may be colored. When the amount of the polymerization initiator is too large, crosslinking at the time of obtaining a cured product proceeds rapidly, and problems such as cracking may occur. On the other hand, if the addition amount of the polymerization initiator is too small, curing the curable composition containing semiconductor nanoparticles becomes difficult.

<Semiconductor Nanoparticle (d)>

Semiconductor nanoparticles (d) are luminescent. As the semiconductor nanoparticles (d), those having an average particle diameter of 1 nm to 1000 nm are preferably used. The particle size of the semiconductor nanoparticle (d) is more preferably less than 20 nm, and even more preferably less than 15 nm. The particle size of the semiconductor nanoparticles (d) is most preferably 2 to 5 nm. When the semiconductor nanoparticle (d) has a particle diameter of 2 nm or more to that less than 20 nm, it becomes a phosphor having a quantum dot effect which confines quantum electrons of the semiconductor nanoparticle (d).

The semiconductor nanoparticle (d) preferably includes a nanoparticle core and a capping layer having protective groups coordinated to the surface of the nanoparticle core.

The protecting group is composed of a hydrocarbon group.

The nanoparticle core of the semiconductor nanoparticle (d) contains ions. Ions contained in the nanoparticle core is not particularly limited, and examples thereof include ions of at least one element selected from the group consisting of Group 2 to Group 16 of the periodic table. It is preferable that the nanoparticle core contains ions of at least one element selected from the group consisting of Groups 3 to 16 of the periodic table.

Further, when the nanoparticle core contains ions of two or more elements, it is preferable that the nanoparticle core contains a first ion and a second ion shown below. The first ion is an ion of at least one element selected from the group consisting of Groups 11 to 14 of the periodic table. The second ion is an ion of at least one element selected from the group consisting of Group 14 to Group 16 of the periodic table.

The nanoparticle core includes a semiconductor material. The semiconductor material used for the nanoparticle core is preferably at least one selected from the group consisting of ZnS, ZnSe, ZnTe, InP, InAs, InSb, AlS, AlAs, AlSb, GaN, GaP, GaAs, GaSb, PbS, PbSe, Si, Ge, MgSe, MgTe, CdS, CdSe, CdTe, CdO, AlP, MgS, and ZnO. Among them, the semiconductor material used for the nanoparticle core is preferably at least one selected from the group consisting of ZnS, ZnSe, ZnTe, InP, InAs, InSb, AlS, AlAs, AlSb, GaN, GaP, GaAs, GaSb, PdS, PbSe, Si, Ge, MgSe, and MgTe.

The semiconductor nanoparticle (d) is preferably a core-shell type in which the surface of the nanoparticle core is covered with a shell made of an inorganic material. The shell may be of a single layer or of two or more layers (core-multishell type).

In the core-shell type semiconductor nanoparticles (d), since the shell promotes the bonding between the nanoparticle core and the protective group, an excellent quantum dot effect can be obtained.

Also, the semiconductor nanoparticles (d) may be doped nanoparticles or inclined nanoparticles.

The amount of the semiconductor nanoparticles (d) in the curable composition containing semiconductor nanoparticles is preferably 0.1 to 20% by mass. When the amount of the semiconductor nanoparticles (d) in the curable composition containing semiconductor nanoparticles is 0.1% by mass or more, the light wavelength converting function by containing the semiconductor nanoparticles (d) is sufficiently obtained. Therefore, the cured product of the curable composition containing semiconductor nanoparticles can be suitably used for electronic parts and optical parts such as an optical lens, an optical element, an optical waveguide and an LED sealing material. When the amount of the semiconductor nanoparticles (d) is 20 % by mass or less, the strength of the cured product can be sufficiently secured.

The semiconductor nanoparticle (d) can adjust the emission wavelength of the semiconductor nanoparticle (d) by changing the average particle size or the material of the nanoparticle core. Therefore, for example, by applying a curable composition containing semiconductor nanoparticles containing semiconductor nanoparticles (d) on the LED surface and curing it, LED in which white light is emitted by the action of light wavelength conversion of the semiconductor nanoparticles (d) can be manufactured.

<Other Components>

The curable composition containing semiconducting nanoparticles of the present invention may contain a polymerization inhibitor, a leveling agent, an antioxidant, an ultraviolet absorber, an infrared absorber, a light stabilizer, a pigment, a filler such as other inorganic filler, a reactive diluent, other modifiers and the like, besides the above essential components, if necessary, as long as they do not impair the viscosity of the composition, and the transparency and heat resistance of the cured product.

The curable composition containing semiconductor nanoparticles of the present invention preferably does not substantially contain an organic solvent and water. "Substantial" here means that it is unnecessary to repeat the desolvation step when a cured product is actually obtained using the curable composition containing semiconductor nanoparticles of the present invention. Specifically, the phrase "substantially not containing an organic solvent and water" means that the residual amount of the organic solvent and water in the curable composition containing semiconductor nanoparticles is preferably 2% by mass or less, and is more preferably 1% by mass or less.

Examples of the polymerization inhibitor include hydroquinone, hydroquinone monomethyl ether, benzoquinone, p-t-butylcatechol, 2,6-di-t-butyl-4-methylphenol and the like. These can be used alone or a combination of two or more may be used.

Examples of the leveling agent include polyether-modified dimethylpolysiloxane copolymer, polyester-modified dimethylpolysiloxane copolymer, polyether-modified methylalkylpolysiloxane copolymer, aralkyl-modified methylalkylpolysiloxane copolymer, polyether modified methyl alkyl polysiloxane copolymer and the like. These can be used alone or a combination of two or more may be used.

Examples of the filler or pigment include calcium carbonate, talc, mica, clay, Aerosil (registered trademark) and the like, barium sulfate, aluminum hydroxide, zinc stearate, zinc white, red iron oxide, azo pigment and the like. These can be used alone or a combination of two or more may be used.

<Method for Producing Curable composition containing semiconductor nanoparticles>

The curable composition containing semiconductor nanoparticles of the present invention can be produced, for example, by carrying out the following Step 1 and Step 2 in this order.

(Step 1) Semiconductor nanoparticles (d) are added to (meth) acrylic monomer (a) and mixed, to obtain a base composition containing semiconductor nanoparticles (d).

(Step 2) The compound (b) and the polymerization initiator (c) are added to the base composition containing the semiconductor nanoparticles (d) obtained in the step 1 and are mixed to obtain a curable composition containing semiconductor nanoparticles. Each process will be disclosed below.

<<Step 1>>

As the semiconductor nanoparticles (d) to be added to the (meth) acrylic monomer (a), it is preferable to use a dispersion in which the semiconductor nanoparticles (d) are dispersed in an organic solvent. Examples of the organic solvent for dispersing the semiconductor nanoparticles (d) include benzene, xylene, toluene and the like. By using such dispersion as the semiconductor nanoparticles (d) source, the semiconductor nanoparticles (d) can be easily dispersed in the acrylic monomer (a).

The method for mixing the (meth) acrylic monomer (a) and the semiconductor nanoparticles (d) is not particularly limited. (Meth) acrylic monomer (a) and the semiconductor nanoparticle (d) are mixed at room temperature by using a mixer such as a mixer, a ball mill, a triple roll or the like. Also, a method in which the (meth) acrylic monomer (a) is placed in a reactor and the semiconductor nanoparticles (d) are added and mixed while continuously stirring the (meth) acrylic monomer (a) in the reactor may be used.

In the case where a dispersion in which the semiconductor nanoparticles (d) are dispersed in an organic solvent is used as the semiconductor nanoparticles (d), the solvent is removed after mixing the (meth) acrylic monomer (a) and the semiconductor nanoparticles (d),

When desolvation is carried out, it is preferable to keep the temperature of the mixed solution of the (meth) acrylic monomer (a) and the semiconductor nanoparticle (d) at 20 to 100°C. If the temperature of the mixed solution is excessively increased at the time of desolvation, the flowability of the curable composition containing semiconductor nanoparticles may be extremely lowered or the gelatinous state may occur. The temperature of the mixed solution of the (meth) acrylic monomer (a) and the semiconductor nanoparticles (d) in the case of performing desolvation is preferably 100°C or less in order to prevent agglomeration and gelling of the curable composition containing semiconductor nanoparticles, is more preferably 70°C or lower, and is still more preferably 50°C or lower. In order to remove the solvent in a short time, the temperature of the mixed solution is preferably 20°C or more, and is more preferably 30°C or more.

In the case of depressurizing the inside of the container for desolvation, in order to carry out desolvation in a short time while preventing aggregation gelation of the curable composition containing semiconductor nanoparticles, it is necessary to set the pressure to 0.1 to 90 kPa, more preferably 0.1 to 50 kPa, and most preferably 0.1 to 30 kPa. If the degree of vacuum in the container at the time of desolvation is too high, the desolvation speed will be extremely slow and economic efficiency may be lost.

The base composition which is a mixture of the (meth) acrylic monomer (a) and the semiconductor nanoparticles (d) after desolvation preferably does not substantially contain an organic solvent and water. "Substantial" here means that it is unnecessary to carry out a desolvation step when a cured product is actually obtained using the curable composition containing semiconductor nanoparticles of the present invention. Specifically, it means that the residual amount of the organic solvent and water contained in the base composition containing the semiconductor nanoparticles (d) is preferably 2 % by mass or less, and is more preferably 1 % by mass or less.

<<Step 2>>

In step 2, the compound (b), the polymerization initiator (c), and other components as necessary are added to the base composition containing the semiconductor nanoparticles (d) obtained in the step 1 and mixed to obtain a curable composition containing semiconductor nanoparticles. There is no particular limitation on the method for mixing these components. For example, a method of mixing the above-mentioned components at room temperature using a mixer such as a mixer, a ball mill, a triple roll or the like can be mentioned. In addition, a method in which the base composition is placed in a reactor and the compound (b), the polymerization initiator (c), if necessary, as well as other components are added and mixed while continuously stirring the base composition in the reactor may be used.

Furthermore, the curable composition containing semiconductor nanoparticles obtained in Step 2 may be filtered. This filtration is carried out in order to remove foreign contamination such as dust contained in the curable composition containing semiconductor nanoparticles. The filtration method is not particularly limited. As a filtration method, for example, it is preferable to use a pressure filtration method using a filter such as a cartridge type filter, a membrane type filter having a pressure filtration pore size of 10 $\mu$m.

Through the above steps, the curable composition containing semiconductor nanoparticles of the present invention is obtained.

[Cured product]

The cured product of the present invention can be obtained by curing the curable composition containing semiconductor nanoparticles of the present invention.

[Method for Producing Cured Product]

The method for producing a cured product of the present invention has a step of curing the curable composition containing semiconductor nanoparticles of the present invention.

As a curing method, for example, a method of crosslinking a (meth)acryloyloxy group by irradiation with active energy rays, a method of thermally polymerizing a (meth)acryloyloxy group by heat treatment may be used.

In the case where the curable composition containing semiconductor nanoparticles is cured by irradiation with actinic energy rays such as ultraviolet rays, in the above-mentioned Step 2, a polymerization initiator (c) as a polymerization initiator is added to the base composition containing the semiconductor nanoparticles (d). In the case of curing the curable composition containing semiconductor nanoparticles by heat treatment, a thermal polymerization initiator is added as a polymerization initiator (c) to the base composition containing the semiconductor nanoparticles (d) in Step 2 disclosed above.

In order to form the cured product of the present invention, for example, the curable composition containing semiconductor nanoparticles of the present invention is coated on a substrate such as a glass plate, a plastic plate, a metal plate or a silicon wafer to form a coating film or the like. Alternatively, a method such as injection into a metal mold or the like can be used. Thereafter, the coating film is irradiated with active energy rays and/or the coating film is cured by heating.

As a coating method of the curable composition containing semiconductor nanoparticles, for example, a method of coating with a bar coater, an applicator, a die coater, a spin coater, a spray coater, a curtain coater or a roll coater, coating by screen printing, coating by dipping or the like can be used.

The coating amount of the curable composition containing semiconductor nanoparticles of the present invention on the substrate is not particularly limited and can be appropriately adjusted according to the purpose. The coating amount of the curable composition containing semiconductor nanoparticles onto the substrate is preferably such that the film thickness of the coating film obtained after the curing treatment by active energy ray irradiation and/or heating is 1 $\mu$m to 10 mm, and is more preferably 10 $\mu$m to 1000 $\mu$m.

The active energy ray used for curing the curable composition containing semiconductor nanoparticles is preferably an electron beam or light in a wavelength range from ultraviolet to infrared. As the light source, for example, an ultra-high pressure mercury light source or a metal halide light source can be used in the case of ultraviolet rays. Further, as the light source, for example, a metal halide light source or a halogen light source can be used in the case of visible light. As the light source, for example, a halogen light source can be used in the case of infrared rays. In addition, for example, a light source such as a laser and an LED can be used.

The irradiation amount of the active energy ray is appropriately set according to the type of the light source, the film thickness of the coating film, and the like.

In addition, after curing the curable composition containing semiconductor nanoparticles by irradiation with active energy rays, curing the curable composition containing semiconductor nanoparticles further proceeds by performing heat treatment (annealing treatment) as necessary. For example, the heating temperature at that time is preferably in the range of 50 to 150 °C. The heating time is preferably in the range of 5 minutes to 60 minutes.

In the case of curing the curable composition containing semiconductor nanoparticles by heating and thermal polymerization, the heating temperature may be set in accordance with the decomposition temperature of the thermal polymerization initiator. It is preferably in the range of 40 to 200°C, and is more preferably in the range of 50 to 150°C. When the heating temperature falls below the above range, it is necessary to increase the heating time, and as a result, the economic efficiency may decrease. When the heating temperature exceeds the above range, it may become less economical because of an increase in the energy cost and it takes time for increasing temperature and decreasing temperature. The heating time is appropriately set according to the heating temperature, the film thickness of the coating film, and the like.

After the curable composition containing semiconductor nanoparticles is cured by thermal polymerization, the curable composition containing semiconductor nanoparticles may be cured further by heat treatment (annealing treatment) as necessary. The heating temperature at that time is preferably in the range of 50 to 150 °C. The heating time is preferably in the range of 5 minutes to 60 minutes.

Through the above steps, the cured product of the present invention is obtained.

The curable composition containing semiconductor nanoparticles of the above embodiment is a curable composition containing a monofunctional (meth)acrylate (a) having a tricyclodecane structure and at least one compound (b) selected from the group consisting of a (meth)acrylate compound (b1) having two or more (meth)acryloyloxy groups and the compound (b2) represented by the above formula (1), the polymerization initiator (c), and the semiconductor nanoparticles. In addition, it is strongly cured by the polymerization reaction of (meth)acrylate (a) and the compound (b). As a result, a cured product having a small linear expansion coefficient, an excellent oxygen barrier property, a high light transmittance, and a high quantum yield can be obtained.

In the curable composition containing semiconductor nanoparticles of the present embodiment, the (meth)acrylate (a) contained in the curable composition containing semiconductor nanoparticles has high interaction and dispersibility with the semiconductor nanoparticle (d). For this reason, the dispersibility of the semiconductor nanoparticles is good, and the handling property is good because of low viscosity even when the solvent not contained. Moreover, when the curable composition containing semiconductor nanoparticles is cured, cure shrinkage is suppressed by the presence of the tricyclodecane structure of the (meth)acrylate (a). Therefore, for example, when the cured product of the curable composition containing semiconductor nanoparticles is a cured film formed on a substrate, warp of the cured product can be suppressed.

In addition, since the curable composition containing semiconductor nanoparticles of the present embodiment contains the compound (b), it is possible to prevent occurrence of cracks in the cured product of the curable composition containing semiconductor nanoparticles. The composition is excellent in formability. In addition, since the curable composition containing semiconductor nanoparticles of the present invention contains the compound (b), the cured product of the curable composition containing semiconductor nanoparticles is not easily brittle.

Since the curable composition containing semiconductor nanoparticles of the present embodiment contains the semiconductor nanoparticles (d), the light wavelength conversion action by the semiconductor nanoparticles (d) can be utilized. Therefore, the cured product of the curable composition containing semiconductor nanoparticles of the present embodiment can be preferably used for electronic parts and optical parts such as an optical lens, an optical element, an optical waveguide and an LED sealing material, for example.

In particular, since the cured product of the curable composition containing semiconductor nanoparticles of the present embodiment has excellent oxygen barrier properties, it is suitable to be used as an LED sealing material.

Example

Hereinafter, the present invention will be disclosed more specifically based on examples, but the present invention is not limited to these examples.

In the following examples and comparative examples, Table 1 and the materials shown below were used.

The numerical values of the amounts of the (meth)acrylates (a), (b1), (e), the polymerization initiator (c) and the semiconductor nanoparticles (d) blended in Tables 1 and 2 are parts by mass.

"(Meth)acrylate (a)"

FA 513 M: 8-methacryloyloxy-tricyclo [5.2.1.0$^{2.6}$] decane (manufactured by Hitachi Chemical Co., Ltd.)

"(Meth)acrylate (b1) (Compound (b))"

IRR 214-K: tricyclodecanedimethanol diacrylate (manufactured by Daicel-Orneck Co., Ltd.)
DCP: tricyclodecanedimethanol dimethacrylate (manufactured by Shin-Nakamura Chemical Co., Ltd.)
SP-1507: bisphenol A diglycidyl ether acrylic acid adduct (manufactured by Showa Denko KK)
TMPTMA trimethylolpropane trimethacrylate (manufactured by Shin-Nakamura Chemical Co., Ltd.)

"(Meth)acrylate (e)"

LMA: lauryl acrylate (manufactured by Hitachi Chemical Co., Ltd.)
IBXMA: isobornyl methacrylate (manufactured by Wako Pure Chemical Industries, Ltd.)
ADMA: adamantyl methacrylate (manufactured by Osaka Organic Chemical Industry Ltd.)

"Polymerization initiator (c)"

Esacure KTO-46 (manufactured by Lamberti, an oligomer of 2-hydroxy-1-(4-isopropenylphenyl)-2-methylpropan-1-one and 2,4,6-trimethylbenzoyldiphenylphosphine oxide and 2,4,6 - trimethylbenzophenone)

"Semiconductor nanoparticles (d)"

RED-CFQD-G2-604 (manufactured by NANOCO TECHNOLOGIES, toluene solution having a semiconductor nanoparticle amount of 10% by mass, nanoparticle core (InP) shell (ZnS), average particle diameter 3 to 4 nm)
GREEN-CFQD-G3-525 (manufactured by NANOCO TECHNOLOGIES, toluene solution having a semiconductor nanoparticle amount of 10 % by mass, nanoparticle core (InP) shell (ZnS), average particle size 2 to 3 nm)

[Example 1]

A base composition containing semiconductor nanoparticles (d) was prepared by adding 7.9g of RED-CFQD-G2-604 (semiconductor nanoparticle amount 10% by mass) which is a semiconductor nanoparticle (d) and 142.1g of GREEN-CFQD-G3-525 (semiconductor nanoparticle amount 10% by mass) to 150 g of 8-methacryloyloxy-tricyclo[5.2.1.0$^{2.6}$]decane (FA 513 M) as a (meth)acrylate compound (a), and then mixing them.
Thereafter, the base composition containing the semiconductor nanoparticles (d) was heated under reduced pressure at 40°C and 0.1 to 30 kPa while stirring to remove volatile components.
Next, a curable composition containing semiconductor nanoparticles of Example 1 was obtained by adding 30 g of tricyclodecanedimethanol diacrylate (IRR 214-K) as the (meth)acrylate (b1), 0.65 g of Esacure KTO-46 as a photopolymerization initiator to the base composition containing the semiconductor nanoparticles (d) in which volatile components was removed, and mixing them.
The curable composition containing semiconductor nanoparticles of Example 1 was applied on a glass substrate (50 mm × 50 mm) to form a coating film so that the cured film after curing had a thickness of 200 μm. Thereafter, the coating film obtained was exposed and cured by an exposure apparatus incorporating an extra-high pressure mercury lamp under the condition of 3 J/cm$^2$. A film was obtained as a cured product of the curable composition containing semiconductor nanoparticles of Example 1.

[Examples 2 to 4]

Curable composition containing semiconductor nanoparticles of Examples 2 to 4 were obtained in the same manner as in Example 1 except that the materials shown in Table 1 were contained in the amounts shown in Table 1.

[Comparative Example 1]

A curable composition containing a semiconductor nanoparticle of Comparative Example 1 was obtained in the same manner as in Example 1, except that the material shown in Table 1 was contained in the amount shown in Table 1, but the (meth)acrylate (b1) was not contained.

[Comparative Example 2]

A curable composition containing a semiconductor nanoparticle of Comparative Example 2 was prepared in the same manner as in Example 1, except that the material shown in Table 1 in the amount shown in Table 1 but the (meth)acrylate (a) was not contained.

[Comparative Examples 3 to 5]

A curable composition containing semiconductor nanoparticles was obtained in the same manner as in Example 1, except that (meth) acrylate (e) shown in Table 1 was used in place of the (meth)acrylate (a) in the amount shown in Table 1.

[Reference Examples 1]

A curable composition not containing the semiconductor nanoparticles of Reference Example 1 was obtained by adding 30g of tricyclodecanedimethanol diacrylate (IRR 214-K) as (meth) acrylate (b1) and 0.65 g of Esacure KTO-46 as a photopolymerization initiator to 150 g of 8-methacryloyloxy-tricyclo[5.2.1.0$^{2.6}$]decane (FA 513 M) as a (meth)acrylate (a), and them mixing them together.

[Reference Examples 2 to 4]

A curable composition not containing semiconductor nanoparticles of Reference Examples 2 to 4 were obtained in the same manner as in Reference Example 1 except that the materials shown in Table 2 were contained in the amounts shown in Table 2.

[Comparative Reference Example 1]

A curable composition not containing semiconductor nanoparticles of Comparative Reference Example 1 was prepared in the same manner as in Reference Example 1 except that it contained no (meth)acrylate (b1) but contained the materials shown in Table 2 in the amounts shown in Table 2.

[Comparative Reference Example 2]

A curable composition not containing semiconductor nanoparticles of Comparative Reference Example 2 was prepared in the same manner as in Reference Example 1 except that no (meth)acrylate (a) was contained but the materials shown in Table 2 were contained in the amounts shown in Table 2.

[Comparative Example Reference 3 to 5]

Curable composition not containing semiconductor nanoparticles of Comparative Reference Examples 3 to 5 were obtained in the same manner as in Reference Example 1 except that the (meth)acrylates (e) were contained in the amounts shown in Table 2 in place of the (meth)acrylates (a).

The dispersibility and quantum yield were evaluated by using the curable composition containing semiconductor nanoparticles of Examples 1 to 4 and Comparative Examples 1 to 5 by the following method. The results are shown in Table 1.

In addition, the appearance, viscosity, film formability, shrinkage rate, glass transition temperature (Tg) and oxygen permeability coefficient were evaluated by using the following methods using the curable composition not containing semiconductor nanoparticles of Reference Examples 1 to 4 and Comparative Reference Examples 1 to 5 prepared in the same manner as the above-described curable composition containing semiconductor nanoparticles except that the composition did not contain semiconductor nanoparticles.

In the curable composition not containing semiconductor nanoparticles of Comparative Reference Example 1, since cracks were formed in the cured film formed by using the curable composition, the shrinkage rate, the glass transition temperature (Tg), and the oxygen permeability coefficient cannot be evaluated. In addition, the curable composition containing semiconductor nanoparticles of Comparative Example 1 was unable to evaluate the quantum yield because the cured film formed using the curable composition containing semiconductor nanoparticles produced cracks. In the curable composition containing semiconductor nanoparticles of Comparative Examples 2, 4 and 5, since semiconductor nanoparticles were precipitated, coating films in which semiconductor nanoparticles were uniformly dispersed could not be formed, and evaluation of quantum yield could not be carried out.

<Appearance>

After the curable composition not containing semiconductor nanoparticles was prepared, it was allowed to stand for 24 hours, and the presence or absence of two-layer separation was visually confirmed with eyes.

<Viscosity>

The viscosity of a curable composition not containing semiconductor nanoparticles was measured using a B type viscometer DV-III ULTRA (manufactured by BROOKFIELD) under a condition of rotor No. 42, rotation number: 1 rpm, 25 °C.

<Film Formability>

A curable composition not containing semiconductor nanoparticles was coated on a glass substrate (50 mm × 50 mm) using a coater to form a coating film so that the cured film (film) after curing had a thickness of 100 $\mu$m. Thereafter, the coating film obtained was exposed and cured by using an exposure apparatus incorporating an extra-high pressure mercury lamp under the condition of 3 J/cm$^2$. Thereafter, the cured film was peeled from the substrate to obtain a film.

A case where the film was crack-free and cracks was not formed when cut with a cutter was evaluated as good.

<Shrinkage Rate>

The specific gravity of the curable composition not containing semiconductor nanoparticles was measured with a density specific gravity meter (DA-650; manufactured by Kyoto Electronics Industry Co., Ltd.). Also, the specific gravity of the film prepared in the same manner as the film formability evaluation was measured with an automatic specific gravity gauge (DMA-220H; manufactured by Shinko Electronics Co., Ltd.). From the specific gravity of the curable composition excluding the semiconductor nanoparticles and the specific gravity of the cured product (film), the shrinkage factor was calculated using the following formula.

$$\text{Shrinkage (\%)} = \{(\text{Specific gravity of cured product - Specific gravity of curable composition excluding semiconductor nanoparticles}) / \text{Specific gravity of cured product}\} \times 100$$

<Glass Transition Temperature (Tg)>

A film prepared in the same manner as in the evaluation of film formability was processed into a length of 30 mm and a width of 5 mm. A glass transition temperature (Tg) was obtained by evaluating peak temperatures of the tan $\delta$ value during rising temperature which was determined by using DMS 6100 (manufactured by Seiko Denshi Kogyo Co., Ltd.) under the conditions of a tensile mode, a temperature range of 30°C to 250 °C, a heating rate of 2 °C/min, and a frequency of 1 Hz.

<Oxygen Permeability Coefficient>

A film was prepared in the same manner as in the evaluation of film formability except that the coating was applied on a glass substrate so that the cured film after curing had a thickness of 200 $\mu$m. The obtained film was cut into a circle having a diameter of 55 mm and the oxygen permeability coefficient [1 × 10$^{-11}$ (cm$^3$ · cm) / (cm$^2$ · sec · cm Hg)] of the film was measured using GTR-30XASD (manufactured by GTR Tec).

<Dispersibility>

The curable composition containing semiconductor nanoparticles was allowed to stand for 24 hours, and presence or absence of sedimentation of the semiconductor nanoparticles (d) was visually confirmed.

\<Quantum yield\>

The film obtained as a cured product of the curable composition containing semiconductor nanoparticles was cut into a circle having a diameter of 15 mm and the quantum yield (%) of the film was measured with a quantum efficiency measuring device QE-1000 manufactured by Otsuka Electronics Co., Ltd.

Measurement condition

Excitation wavelength: 450 nm
Measurement temperature: 25 °C
Measurement wavelength range: 490 to 800 nm
Emission wavelength 1: 535 to 545 nm
Emission wavelength 2: 605 to 635 nm

[Table 1]

| (Numbers of formulation are parts by mass) | | Example 1 | Example 2 | Example 3 | Example 4 | Comp. Example 1 | Comp. Example 2 | Comp. Example 3 | Comp. Example 4 | Comp. Example 5 |
|---|---|---|---|---|---|---|---|---|---|---|
| (Meth)acrylate (a) | FA 513 M | 150 | 150 | 150 | 150 | 180 | | | | |
| (Meth)acrylate (bl) | IRR 214K | 30 | | | | | 180 | | | |
| | DCP | | 30 | | | | | | | |
| | SP-1507 | | | 30 | | | | | | |
| | TMPTMA | | | | 30 | | | 30 | 90 | 90 |
| (Meth)acrylate (e) | LMA | | | | | | | 150 | | |
| | IBXMA | | | | | | | | 90 | |
| | ADMA | | | | | | | | | 90 |
| Polymerization initiator (c) | KTO - 46 | 0.65 | 0.65 | 0.65 | 0.65 | 0.65 | 0.65 | 0.65 | 0.65 | 0.65 |
| Semiconductor nanoparticles (d) | RED | 0. 79 | 0. 79 | 0. 79 | 0. 79 | 0. 79 | 0. 79 | 0. 79 | 0. 79 | 0. 79 |
| | GREEN | 14.21 | 14.21 | 14.21 | 14.21 | 14.21 | 14.21 | 14.21 | 14.21 | 14.21 |
| Curable composition containing semiconductor nanoparticles | Dispersibility of semiconductor nanoparticles | Good | Good | Good | Good | Good | Precipitation | Good | Precipitation | Precipitation |
| | Quantum yield of cured product (9) | 46 | 29 | 43 | 34 | --- | --- | 25 | --- | --- |

[Table 2]

| (Numbers of formulation are parts by mass) | | Ref. Example 1 | Ref. Example 2 | Ref. Example 3 | Ref. Example 4 | Comp. Ref. Example 1 | Comp. Ref. Example 2 | Comp. Ref. Example 3 | Comp. Ref. Example 4 | Comp. Ref. Example 5 |
|---|---|---|---|---|---|---|---|---|---|---|
| (Meth)acrylate (a) | FA 513 M | 150 | 150 | 150 | 150 | 180 | | | | |
| (Meth> acrylate (bl) | IRR 214K | 30 | | | | | 180 | | | |
| | DCP | | 30 | | | | | | | |
| | SP-1507 | | | 30 | | | | | | |
| | TMPTMA | | | | 30 | | | 30 | 90 | 90 |
| (Meth) acrylate (e) | LMA | | | | | | | 150 | | |
| | IBXMA | | | | | | | | 90 | |
| | ADMA | | | | | | | | | 90 |
| Polymerization initiator (c) | KTO - 46 | 0.65 | 0.65 | 0.65 | 0.65 | 0.65 | 0.65 | 0.65 | 0.65 | 0.65 |
| Appearance (presence or absence of two-layer separation) | | Nothing | Nothing | Nothing | Nothing | Nothing | Nothing | Nothing | Nothing | Nothing |
| Viscosity (mPa • s @ 25 °C) | | 30 | 30 | 50 | 20 | 10 | 120 | 10 | 22 | 30 |
| Film formability | | Good | Good | Good | Good | crack | Good | Good | Good | Good |
| Shrinkage factor(%) | | 2.39 | 3.63 | 3.21 | 5.04 | | 5.90 | 11.1 | 8.77 | 8.44 |
| Glass transition temperature (°C) | | 80 | 87 | 75 | 82 | | 191 | 40 | 168 | 173 |
| Oxygen permeability coefficient $[1 \times 10^{-11}] (cm^3 \cdot cm)/(cm^2 \cdot sec \cdot cmHg)$ | | 8. 95 | 41.9 | 28.9 | 9.41 | | 7.24 | 118 | 12. 1 | 8.63 |

As shown in Tables 1 and 2, the evaluation results of Examples 1 to 4 and Reference Examples 1 to 4 were all good.

The appearance, viscosity, film formability, shrinkage rate, glass transition temperature, and oxygen permeability coefficient were evaluated using curable compositions not containing semiconductor nanoparticles of Reference Examples 1 to 4, but these items are not different in magnitude and trends from the case of evaluating by adding semiconductor nanoparticles to a curable composition not containing semiconductor nanoparticles used for evaluation. Therefore, the curable composition not containing the semiconductor nanoparticles of Reference Examples 1 to 4 can be suitably used by adding semiconductor nanoparticles thereto.

On the other hand, in Comparative Reference Example 1 containing no (meth)acrylate (b1), cracking occurred and film formability was insufficient.

In Comparative Example 2 which does not contain the (meth)acrylate (a), the semiconductor nanoparticles (d) precipitated, and good dispersibility could not be obtained. In Comparative Reference Example 2, since it did not contain the (meth)acrylate (a), the viscosity was very high.

In Comparative Reference Example 3 containing (meth)acrylate (e) instead of (meth)acrylate (a) of Reference Example 4 in the same amount as (meth)acrylate (a) of Reference Example 4, the oxygen permeability coefficient and the shrinkage ratio were very high. In Comparative Example 3, the quantum yield was lower than in Example 4.

Further, in Comparative Examples 4 and 5 containing (meth)acrylate (e) instead of (meth)acrylate (a), semiconductor nanoparticles (d) precipitated and good dispersibility could not be obtained.

**Claims**

1. A curable composition containing semiconductor nanoparticles comprising
   a monofunctional (meth)acrylate compound (a) having a tricyclodecane structure,
   at least one compound (b) selected from the group consisting of a (meth)acrylate compound (b1) having two or more (meth)acryloyloxy groups and a compound (b2) represented by the following formula (1),
   a polymerization initiator (c), and
   a luminescent semiconductor nanoparticle (d),

   $$H_2C=C(R^1)-CH_2-O-CH_2-C(R^2)=CH_2 \qquad (1)$$

   wherein $R^1$ and $R^2$ each independently represent a hydrogen atom, an alkyl group having 1 to 4 carbon atoms, or an organic group having 4 to 10 carbon atoms having an ester bond.

2. The curable composition containing semiconductor nanoparticles according to claim 1,
   wherein the amount of the (meth)acrylate compound (a) with respect to the total mass of the (meth)acrylate compound (a) and the compound (b) is 75 to 99.5 % by mass.

3. The curable composition containing semiconductor nanoparticles according to claim 1 or 2,
   wherein the semiconductor nanoparticle (d) has a nanoparticle core comprising an ion which is at least one element selected from the group consisting of Groups 2 to 16 of the periodic table.

4. The curable composition containing semiconductor nanoparticles according to claim 3,
   wherein the nanoparticle core is selected from the group consisting of ZnS, ZnSe, ZnTe, InP, InAs, InSb, AlS, AlAs, AlSb, GaN, GaP, GaAs, GaSb, PdS, PbSe, Si, Ge, MgSe, and MgTe.

5. The curable composition containing semiconductor nanoparticles according to any one of claims 1 to 4,
   wherein the semiconductor nanoparticle (d) comprises a nanoparticle core and a capping layer having a protective group coordinated to the surface of the nanoparticle core, and
   the surface of the nanoparticle core is coated with at least one shell of an inorganic material.

6. The curable composition containing semiconductor nanoparticles according to any one of claims 1 to 5,
   wherein the amount of the semiconductor nanoparticles (d) in the curable composition containing semiconductor nanoparticles is 0.1 to 20% by mass.

7. A cured product obtained by curing the curable composition containing semiconductor nanoparticles according to any one of claims 1 to 6.

**8.** An optical material comprising the cured product according to claim 7.

**9.** An electronic material comprising the cured product according to claim 7.

## INTERNATIONAL SEARCH REPORT

| | International application No. |
|---|---|
| | PCT/JP2015/083246 |

### A. CLASSIFICATION OF SUBJECT MATTER

*C08F220/12*(2006.01)i, *B82Y20/00*(2011.01)i, *B82Y30/00*(2011.01)i, *C08F2/44* (2006.01)i, *C08F216/12*(2006.01)i, *G02B1/04*(2006.01)i, *H01L33/50*(2010.01)i, *H01L33/56*(2010.01)i

According to International Patent Classification (IPC) or to both national classification and IPC

### B. FIELDS SEARCHED

Minimum documentation searched (classification system followed by classification symbols)
C08F2/00-2/60, C08C19/00-19/44, C08F6/00-246/00, C08F301/00, B82Y20/00, B82Y30/00, G02B1/04, H01L33/50, H01L33/56

Documentation searched other than minimum documentation to the extent that such documents are included in the fields searched

| | | |
|---|---|---|
| Jitsuyo Shinan Koho | 1922-1996 | Jitsuyo Shinan Toroku Koho 1996-2016 |
| Kokai Jitsuyo Shinan Koho | 1971-2016 | Toroku Jitsuyo Shinan Koho 1994-2016 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2013-067673 A (Hitachi Chemical Co., Ltd.), 18 April 2013 (18.04.2013), claims; examples & CN 103013357 A | 1-9 |
| A | JP 2010-126596 A (Showa Denko Kabushiki Kaisha), 10 June 2010 (10.06.2010), (Family: none) | 1-9 |
| A | JP 2005-171135 A (Dainippon Ink and Chemicals, Inc.), 30 June 2005 (30.06.2005), (Family: none) | 1-9 |

☒ Further documents are listed in the continuation of Box C.    ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 January 2016 (14.01.16) | 26 January 2016 (26.01.16) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (January 2015)

**EP 3 228 640 A1**

**INTERNATIONAL SEARCH REPORT**

International application No.

PCT/JP2015/083246

C (Continuation). DOCUMENTS CONSIDERED TO BE RELEVANT

| Category* | Citation of document, with indication, where appropriate, of the relevant passages | Relevant to claim No. |
|---|---|---|
| A | WO 2013/015125 A1 (JNC Corp.), 31 January 2013 (31.01.2013), & EP 2738226 A1 & CN 103649244 A & KR 10-2014-0054022 A | 1-9 |
| A | JP 2010-126680 A (Kaneka Corp.), 10 June 2010 (10.06.2010), (Family: none) | 1-9 |
| A | JP 2013-018827 A (Showa Denko Kabushiki Kaisha), 31 January 2013 (31.01.2013), (Family: none) | 1-9 |
| P,X P,A | WO 2015/019941 A1 (Showa Denko Kabushiki Kaisha), 12 February 2015 (12.02.2015), claims 1 to 10; examples 6, 8, 10, 21; comparative examples 6, 9 & TW 201518359 A | 1,3-9 2 |
| E,A | WO 2015/186521 A1 (Showa Denko Kabushiki Kaisha), 10 December 2015 (10.12.2015), (Family: none) | 1-9 |

Form PCT/ISA/210 (continuation of second sheet) (January 2015)

19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014245851 A
- JP 2009102514 A
- WO 2010001875 A
- JP 5186848 B
- JP 2010126596 A